# EUROPEAN PATENT APPLICATION

(11) **EP 0 552 890 A2**
(43) Date of publication of application: **28.07.1993**
(21) Application number: 93300239.6
(22) Date of filing: 14.01.1993
(51) Int. Cl.: G01R 33/06, G11B 5/00, G11B 5/39

(54) **Magnetic sensor**

(30) Priority: 21.01.1992 US 822776
(71) Applicant: International Business Machines Corporation, Armonk, N.Y. 10504 (US)
(72) Inventor: Howard, James Kent, Morgan Hill, California 95037 (US); Hwang, Chernyge, San Jose, California 95119 (US); Lee, James Hsi-tang, San Jose, California 95120 (US)
(74) Representative: Burt, Roger James, Dr.

(57) **Abstract**

A magnetoresistive (MR) sensor 31 having electrically conductive lead structures 38,41 which are in electrical contact with the MR element 32 at spaced positions. The lead structures comprise a thin film layer of ruthenium, iridium or rhodium to serve as the principal current carrying element. A thin film overlayer or both a thin film underlayer and overlayer may be utilized to provide an adhesion layer for the principal current carrying element. Both the overlayer and underlayer are formed of a material taken from the group consisting of Ti and Ta.

## Description

This invention relates in general to magnetic sensors for reading information signals from a magnetic medium, and in particular, to a magnetoresistive read transducer.

The prior art discloses a magnetic transducer referred to as magnetoresistive (MR) sensor or head which has been shown to be capable of reading data from a magnetic surface at high linear densities. An MR sensor detects magnetic field signals through the resistance changes of a read element fabricated of a magnetoresistive material as a function of the amount and direction of magnetic flux being sensed by the element.

In the past, unstable operating characteristics have presented principal problems with the MR sensors which have limited their use. One of the sources of unstable operating characteristics has been the conductive lead structures by which resistance variations of the MR film element are sensed. Typically, the conductive lead structures have comprised the well-known, low resistivity materials which are good electrical conductors. For example, U.S. Patent No. 4,622,613 to Nomura, et al. describes an MR sensor in which the conductive lead structures are formed of copper, gold, and silver. U.S. Patent No. 4,663,684 to Kamo, et al. describes an MR sensor in which the conductive lead structures are formed of gold or aluminum.

Other conductive lead structures have utilized multi-layer configurations. U.S. Patent No. 4,503,394 discloses an MR sensor in which the conductive lead structures are formed of a two-layer assembly in which the first layer is made from a material selected from the group consisting of Cr, Mo, and Ti and the second layer is made from a material selected from the group consisting of AI, Au, Pt and Pd. U.S. Patent No. 4,914,538 discloses an MR sensor having a lead structure comprising a thin film of tungsten having a thin film overlayer, or, alternatively, a thin film overlayer and a thin film underlayer, with both the thin film overlayer and the thin film underlayer formed of a material taken from the group consisting of Ti, Ta, Cr, Zr, Hf and TiW.

Problems that have arisen in MR sensors utilizing prior art conductive lead structures include high stress, poor adhesion and etchant penetration during subsequent sensor processing. In addition, problems associated with interdiffusion and electromigration have caused changes in the electrical characteristics of the sensor during the operational life of the MR sensors.

In the MR conductor lead application, the materials face much more stringent requirements when compared to other interconnect conductors, such as for semiconductor devices, for example. This is because the conductor lead is exposed at the slider air bearing surface and therefore has little protection from the severe mechanical environment where head-disk contact frequently occurs and the severe corrosion environment where chemical attack occurs both during subsequent processing and also in actual use where the operating environment may not be well controlled. Thus the lead structure must exhibit sufficient mechanical stability to withstand occasional contact with the disk and chemical stability to withstand the corrosive environment that may occur during the operating lifetime of a disk file in which the MR sensor is installed. Additionally, since elevated temperatures, up to 250°C, for example, are encountered in various processing steps for the MR sensor, a further requirement is that the resistivity of the lead structure remain stable in the presence of the subsequent thermal processing.

It is accordingly an object of this invention to provide a magnetic sensor having lead structures which remain stable not only during processing of the sensor but also over its useful life.

According to the invention there is provided a magnetic sensor comprising a layer of magnetoresistive material formed on a substrate; and a plurality of electrically conductive lead structures electrically contacting said layer of magnetoresistive material at spaced positions, each said electrically conductive lead structure comprising a layer of a material selected from the group consisting of ruthenium, iridium and rhodium, whereby, when a signal output means is connected between two of said electrically conductive lead structures, resistance changes in said magnetoresistive material responsive to magnetic fields which are intercepted by said layer of magnetoresistive material can be detected.

There is further provided a magnetic sensor comprising a layer of magnetoresistive material formed on a substrate; at least two electrically conductive lead structures electrically contacting said layer of magnetoresistive material at spaced positions, each said electrically conductive lead structure comprising a layer of a material taken from the group consisting of ruthenium, iridium and rhodium, an underlayer in contact with said layer of magnetoresistive material and an overlayer, said underlayer and said overlayer forming adhesion layers for said layer, said underlayer and said overlayer being coextensive with said layer in said lead structures, whereby, when a signal output means is connected between two of said electrically conductive lead structures, resistance changes in said magnetoresistive material responsive to magnetic fields which are intercepted by said layer of magnetoresistive material can be detected. The lead structures preferably comprise a principal current carrying layer formed of a thin film layer of ruthenium, iridium or rhodium in contact with the MR material and either a thin film overlayer or both a thin film overlayer and a thin film underlayer to provide an adhesion layer for the principal current carrying layer. Both the thin film overlayer and the thin film underlayer are formed of a material taken from the group consisting of titanium and tantalum. When a signal sensing means is connected between two of the electrically conductive lead structures, the resistance changes in the MR material as a function of the magnetic fields intercepted by the MR sensor can be detected.

In order that the invention may be well understood, a preferred embodient thereof will now be described with referenceto the accompanying drawings, in which:
Fig. 1 is a simplified block diagram of a magnetic disk storage system embodying the present invention;
Fig. 2 is an end view of a specific embodiment of an MR read transducer assembly embodying the present invention;
Fig. 3 is a plan view of the transducer shown in Fig. 2;
Fig. 4 is a bar graph illustrating the hardness of various materials suitable for use as a principal current carrier in the lead structures according to the present invention;
Fig. 5 is a bar graph illustrating the corrosion resistance properties of various materials suitable for use as a principal current carrier in the lead structures according to the present invention;
Figs. 6a and 6b are graphical diagrams illustrating the thermal stability of resistivity for various material combinations used in lead structures according to the present invention;
Fig. 7 is a partial section view taken along lines 7-7 of Fig. 3; and
Fig. 8 is a partial section view taken along lines 7-7 of Fig. 3 of an alternate embodiment of an MR read transducer assembly according to the present invention.

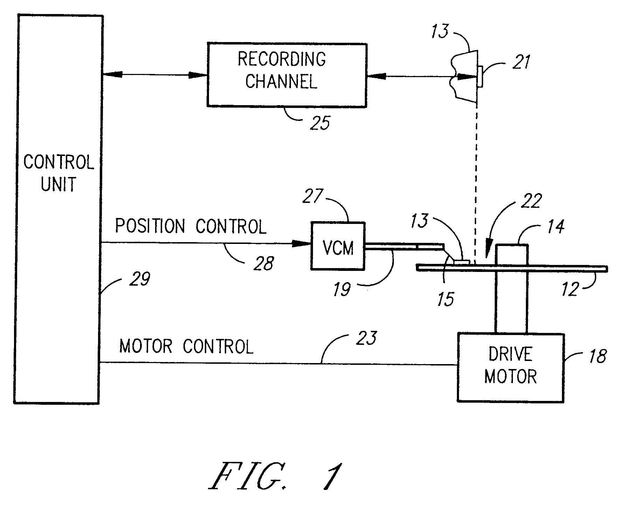

Although the present invention is described as embodied in a magnetic disk storage system as shown in Fig. 1, it will be apparent that the invention is also applicable to other magnetic recording systems such as a magnetic tape recording system, for example. At least one rotatable magnetic disk 12 is supported on a spindle 14 and rotated by a disk drive motor 18. The magnetic recording media on each disk is in the form of an annular pattern of concentric data tracks (not shown) on disk 12.

At least one slider 13 is positioned on the disk 12, each slider 13 supporting one or more magnetic read/write heads 21. As the disks rotate, the sliders 13 are moved radially in and out so that the heads 21 may access different portions of the disk surface 22 containing the data. Each slider 13 is attached to an actuator arm 19 by means of a suspension 15. The suspension 15 provides a slight spring force which biases the slider 13 against the disk surface 22. Each actuator arm 19 is attached to an actuator means 27. The actuator means shown in Fig. 1 is a voice coil motor (VCM). The VCM is a coil moveable within a fixed magnetic field, and the direction and velocity of the coil movements are controlled by the current supplied.

During operation of the disk storage system, the rotation of the disk 12 generates an air bearing between the slider 13 and the disk surface 22. The air bearing thus counterbalances the slight spring force of the suspension 15 and supports the slider 13 off the disk surface by a small, substantially constant spacing during operation.

The various components of the disk storage system are controlled in operation by signals generated by control unit 29, such as access control signals and internal clock signals, and which includes logic control circuits, storage means and a microprocessor. The control unit 29 generates control signals to control various system operations such as motor control signals on line 23 and head position control signals on line 28. The control signals on line 28 provide the desired current profiles to optimally move and position a selected slider 13 to the desired data track on the associated disk 12. Read and write signals are communicated to and from read/write heads 21 by means of recording channel 25.

The above description of a typical magnetic disk storage system, and the accompanying illustration of it in Fig. 1 are for representation purposes only. It should be apparent that disk storage systems may contain a large number of disks and actuators, and each actuator may support a number of sliders.

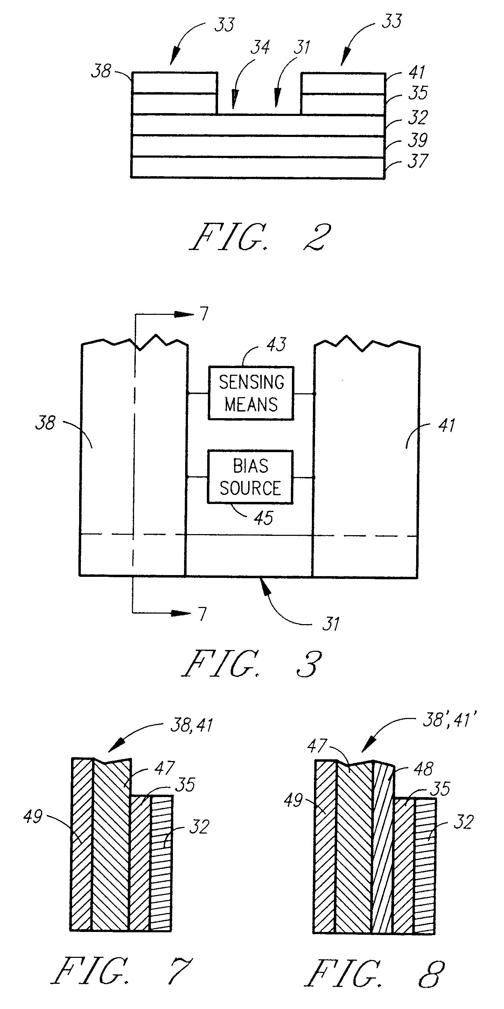

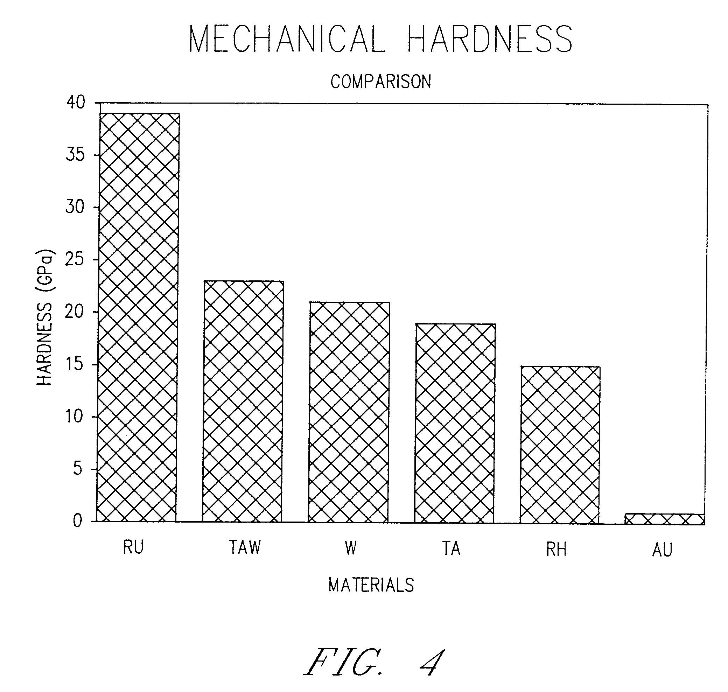

A specific embodiment of a magnetoresistive read transducer assembly will be described briefly in conjunction with Fig. 2. The magnetic read head utilizes a magnetoresistive (MR) sensor 31 produced on a suitable substrate (not shown). The MR sensor 31 can be divided into two regions, the central active region 34, where actual sensing of data is accomplished, and end regions 33. The two regions 33, 34 should be biased in different manners with longitudinal bias only in the end regions 33 and transverse bias only in the active region 34. The longitudinal bias in the end regions 33 is produced by a bias layer 35 which is deposited to be in direct physical contact with MR layer 32. Bias layer 35 may comprise either an antiferromagnetic material or a hard magnetic material. The transverse bias in the active region 34 is produced by a soft magnetic film layer 37 which is separated from the MR layer 32 by a thin nonmagnetic spacer layer 39 whose purpose is to prevent, within the active central region, a magnetic exchange coupling between the MR layer 32 and the soft magnetic bias layer 37. That portion of the MR sensor 31 between the inner edges of conductive lead structures 38 and 41 (as shown in Fig. 3) comprises the portion of the active region 34 over which the output signal is developed.

With reference now to Fig. 3, an output signal iₛ, can be coupled out to sensing means 43, with the aid of conductive lead structures 38 and 41 which are electrically connected to the MR sensor 31. The signal iₛ enables the sensing means 43 to determine the resistance changes in the central region 34 resulting from the magnetic fields which are intercepted by the MR sensor 31 from previously recorded data on a magnetic medium, for example. A bias source 45 is also connected to conductive lead structures 38 and 41 to supply a bias current which, in conjunction with a soft magnetic bias film layer 37, produces the transverse bias in the active region 34 as is known in the art. Typically, sensing means 43 and bias source 45 may be incorporated in the read/write channel circuitry 25 (as shown in Fig. 1).

According to the present invention, the principal current carrying element of the conductive lead structures 38 and 41 is fabricated of ruthenium (Ru), iridium (Ir) or rhodium (Rh). While it has been found that Ru, Ir or Rh alone will provide a reliable conductive lead structure in thin film form, adhesive layers on one or both sides of the principal current carrying layer provide increased reliability in an operational environment. Therefore, a preferred structure is provided for conductive lead structures 38, 41 comprising a thin film layer of Ru, Ir or Rh with a thin film overlayer formed of a material selected from the group consisting of titanium (Ti) and tantalum (Ta). Alternatively, the conductive lead structure 38, 41 comprises a thin film layer of Ru, Ir or Rh with a thin film underlayer and a thin film overlayer, with both the underlayer and overlayer formed of a material selected from the group consisting of Ti and Ta.

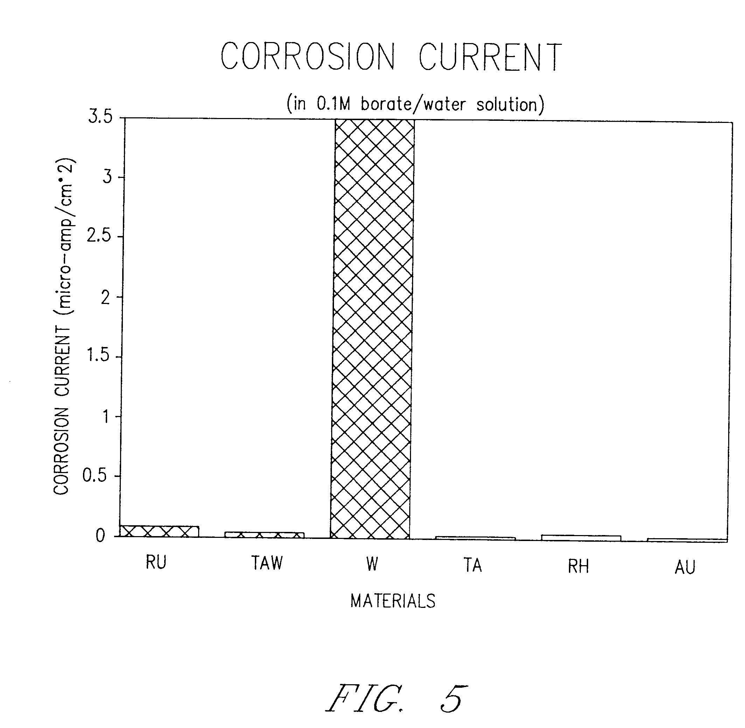

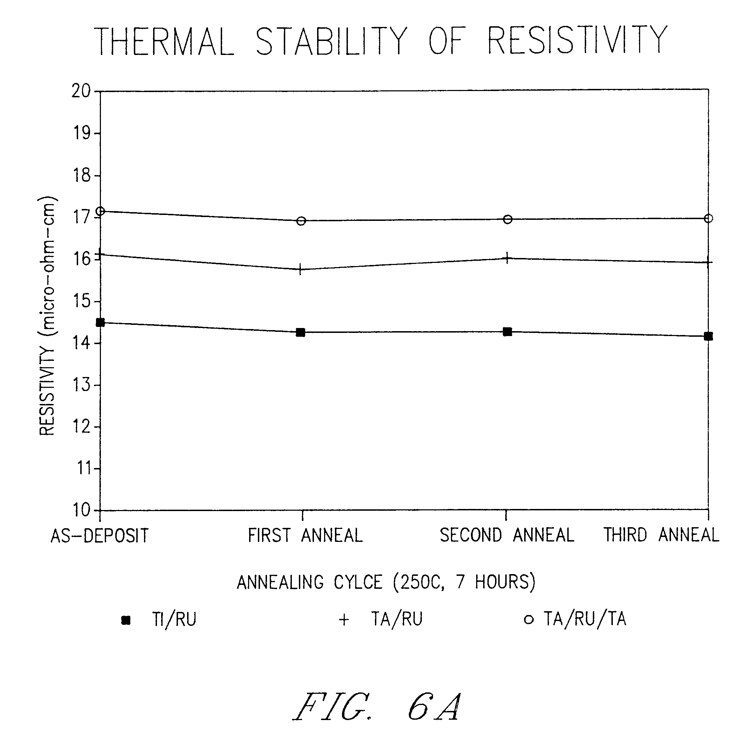

All three materials, Ru, Ir and Rh are suitable for the conductive lead structures 38, 41 since they have excellent hardness and corrosion characteristics, as shown in Figs. 4 and 5, and have little tendency to interdiffuse into adjacent layers. The hardness and mechanical strength of Ru, Ir and Rh provide protection against mechanical damage such as scratching and smearing (shorting). Additionally, they possess high resistance to electromigration, a requirement in the greater than 10⁷ amp per cm² environment encountered in MR head applications. The bulk resistivity of Ru, Ir and Rh is about 7.5µΩcm, 5.1µΩcm and 4.5µΩcm, respectively. While this resistivity is higher than conventional conductor lead materials such as gold, it is low enough to be used without extensive redesign of existing circuits for sensing the read signal generated by an MR sensor.

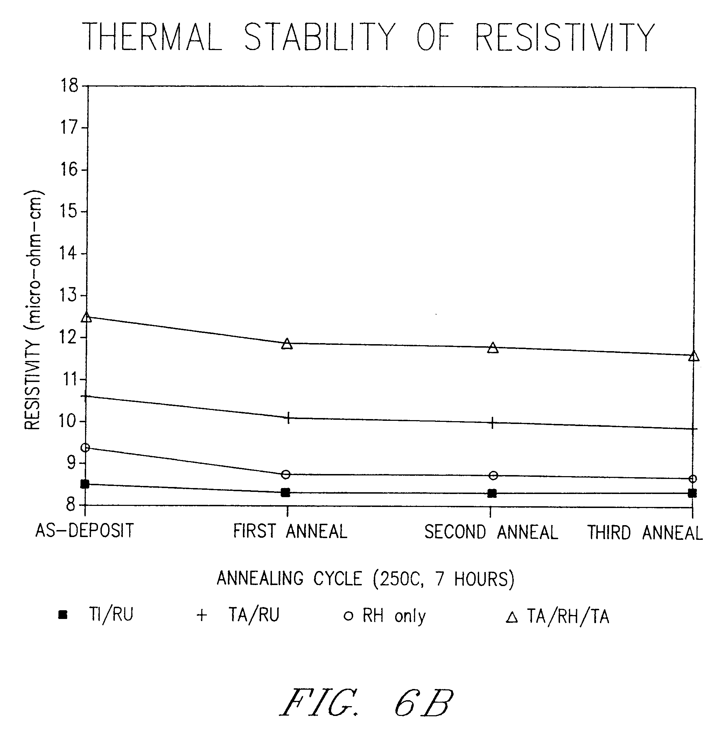

Referring now to Figs. 6a and 6b, the resistivities for various thin film lead structures utilizing Ru, Ir and Rh, respectively, are illustrated. Typical resistivities of Ru, Ir and Rh thin film layers of nominally 2000Å thick, with and without adhesion layers, are in the range of 13-18µΩcm, 15-17µΩcm and 9-13µΩcm, respectively. The lower end of each range represents the resistivity values observed for single-layer films of Ru, Ir and Rh, while the higher end of each range represents the values observed for two- or three-layer structures comprising a thin film layer of Ru, Ir or Rh with thin (approximately 200Å) adhesion layers of Ta or Ti on the bottom and/or top of the Ru, Ir or Rh layer. Figs. 6 and 7 also illustrate the thermal stability of these lead structures. Measurement of the resistivity after each of several heat treatment cycles demonstrate that the resistivities of these structures are very stable showing little change in initial resistivity values over several cycles. Each heat treatment cycle consists of 7 hours at 250°C including a 5-hour ramp-up period, a typical hard-bake resist process utilized in the fabrication of thin film MR heads.

Referring now to Fig. 7, a specific embodiment of the present invention is shown. Conductive lead structures 38, 41 comprise a principal current carrying thin film layer 47 of Ru, Ir or Rh preferably having a thickness within the range of 1000-5000Å. The Ru, Ir or Rh layer 47 is covered with an adhesion overlayer 49, preferably having a thickness within the range of 25-200Å. A suitable adhesion overlayer is formed of a material selected from the group consisting of Ti and Ta. Any remaining bias layers are not shown in Fig. 7, but would typically have the same arrangement as the MR sensor 31 layers shown in Fig. 2 since these layers are normally patterned in the same processing step.

Referring now to Fig. 8, an alternate embodiment of the conductive lead structure is shown. In this embodiment the conductive lead structures 38', 41' comprise an adhesion underlayer 48 having a thickness preferably within the range of 25-200Å. The principal current carrying layer 47 is provided by a thin film layer of Ru, Ir or Rh formed on underlayer 48. The thin film layer 47 of Ru, Ir or Rh has a thickness within the range of 1000-5000Å. The Ru, Ir or Rh layer 47 is covered with an adhesion overlayer 49 having a thickness preferably within the range of 25-200Å. Both the underlayer 48 and the overlayer 49 are formed of a material selected from the group consisting of Ti and Ta.

A lead structure has been described, according to the present invention, which remains stable not only during subsequent processing of the MR sensor during manufacturing but also during the anticipated useful life of the MR sensor in an operational disk file.

While the invention has been particularly shown and described with reference to a preferred embodiment thereof, it will be understood by those skilled in the art that various other changes in the form and details may be made therein without departing from the spirit and scope of the invention.

## Claims

1. A magnetic sensor comprising a layer of magnetoresistive material formed on a substrate; and a plurality of electrically conductive lead structures electrically contacting said layer of magnetoresistive material at spaced positions, each said electrically conductive lead structure comprising a layer of a material selected from the group consisting of ruthenium, iridium and rhodium, whereby, when a signal output means is connected between two of said electrically conductive lead structures, resistance changes in said magnetoresistive material responsive to magnetic fields which are intercepted by said layer of magnetoresistive material can be detected.

2. A sensor as claimed in claim 1 wherein each said electrically conductive lead structure further comprises an overlayer formed of a material taken from the group consisting of titanium and tantalum, said overlayer being coextensive with said layer in said lead structure.

3. A sensor as claimed in claim 2 wherein each said electrically conductive lead structure further comprises an underlayer formed of a material taken from the group consisting of titanium and tantalum, said underlayer being coextensive with said layer in said lead structure.

4. A sensor as claimed in claim 2 or claim 3 wherein said layer is 1000-5000 angstroms thick and said overlayer is 25-200 angstroms thick.

5. A magnetic sensor as claimed in claim 3 wherein said layer is 1000-5000 angstroms thick and said overlayer and said underlayer are 25-200 angstroms thick.

6. A magnetic sensor as claimed in claim 1 wherein said layer is 1000-5000 angstroms thick.

7. A magnetic storage system comprising: a magnetic storage medium having a plurality of tracks for recording of data; a magnetic transducer maintained in a closely spaced position relative to said magnetic storage medium during relative motion between said magnetic transducer and said magnetic storage medium, said magnetic transducer further comprising: a layer of magnetoresistive material formed on a substrate; and a plurality of electrically conductive lead structures electrically contacting said layer of magnetoresistive material at spaced positions, each said electrically conductive lead structure comprising a layer of a material selected from the group consisting of ruthenium, iridium and rhodium; actuator means coupled to said magnetic transducer for moving said magnetic transducer to selected tracks on said magnetic storage medium; and means coupled between two of said electrically conductive lead structures for detecting resistance changes in said magnetoresistive material responsive to magnetic fields representative of data bits recorded in said magnetic storage medium intercepted by said layer of magnetoresistive material.

8. A system as claimed in claim 7 wherein each said electrically conductive lead structure further comprises an overlayer formed of a material taken from the group consisting of titanium and tantalum, said overlayer being coextensive with said layer in said lead structure.

9. A system as claimed in claim 8 wherein each said electrically conductive lead structure further comprises an underlayer formed of a material taken from the group consisting of titanium and tantalum, said underlayer being coextensive with said layer in said lead structure.

10. A system as claimed in claim 9 wherein said layer is 1000-5000 angstroms thick and said overlayer is 25-200 angstroms thick.

11. A system as claimed in claim 10 wherein said overlayer and said underlayer is 25-200 angstroms thick.

12. A system as claimed in claim 7 wherein said layer is 1000-5000 angstroms thick.
